# EUROPÄISCHE PATENTANMELDUNG

(11) **EP 0 601 478 A1**
(43) Veröffentlichungstag der Anmeldung: **15.06.1994**
(21) Anmeldenummer: 93119423.7
(22) Anmeldetag: 02.12.1993
(51) Int. Cl.: H03F 1/34

(54) **Transistorverstärkerkaskade**

(30) Priorität: 04.12.1992 DE 4240881
(71) Anmelder: Alcatel SEL Aktiengesellschaft, D-70435 Stuttgart (DE)
(72) Erfinder: Steigenberger, Ulrich, D-70565 Stuttgart (DE)
(74) Vertreter: Schätzle, Albin, Dipl.-Phys.

(57) **Zusammenfassung**

Verstärkerkaskaden für Wechselspannungen mit wenigstens zwei Transistorverstärkerstufen mit Bipolar- oder Feldeffekttransistoren, wie sie insbesondere bei der Übertragung von Breitbandsignalen zur Signalaufbereitung in einem Analogteil eines Regenerators oder als Antennenverstärker Verwendung finden, haben häufig für jede dieser Transistorverstärkerstufen u.a. eine Spannungsgegenkopplung mit jeweils einem Kondensator.

Derartige Verstärkerkaskaden sollen einen möglichst kompakten Aufbau besitzen, um parasitäre Effekte zu vermeiden und die Integrationsfreundlichkeit zu erhöhen.

Durch Mehrfachausnutzung vorhandener Bauelemente, hier insbesondere eines zur Kopplung zweier Transistorverstärkerstufen (11, 21) verwendeten Kondensators (C3), der nun zusätzlich aufgrund geeigneter Verschaltung zur Spannungsgegenkopplung der beiden Transistorverstärkerstufen (11, 21) benutzt wird, und der Verwendung von nur noch einem Basis- oder Gateteiler, wird die Bandbreite vergrößert und die Stabilität verbessert.

## Beschreibung

Die Erfindung betrifft eine Verstärkerkaskade für Wechselspannungen, insbesondere zur Übertragung von Breitbandsignalen, wie sie unter anderem zur Signalaufbereitung in einem Analogteil eines Regenerators oder als Antennenverstärker verwendet wird.

Es ist allgemein bekannt, daß derartige Verstärkerkaskaden aus einer Kaskade von Transistorverstärkerstufen bestehen können, von denen die erste eine Leitungsanpassung am Eingang und die letzte eine Leitungsanpassung am Ausgang der Verstärkerkaskade vornimmt.

Eine solche Verstärkerkaskade ist aus "Berechnung von Verstärkerschaltungen" von H. Römisch, 2. Aufl., B.G. Teubner Stuttgart 1978, S. 49/50 bekannt. Die dort dargestellte Verstärkerkaskade weist zwei Transistorverstärkerstufen auf, die jeweils einen Bipolartransistor in Emitterschaltung als aktives Bauelement und ein passives Netzwerk zur Beschaltung des Bipolartransistors enthalten.

Die zwei Transistorverstärkerstufen sind über einen Kondensator miteinander verbunden, d.h. der Kollektor des Transistors einer ersten Transistorverstärkerstufe ist über diesen Kondensator mit der Basis des Transistors einer zweiten Transistorverstärkerstufe verbunden.

Wie aus "Halbleiterschaltungstechnik" von U. Tietze, Ch. Schenk, 8. Aufl., Springerverlag 1986, S. 44-52, bekannt ist, kann das passive Netzwerk jeweils einen Zweig zur Strom- und Spannungsgegenkopplung und einen Basisteiler zur Einstellung des Arbeitspunktes des Transistors haben.

Aufgabe der Erfindung ist es, eine universell einsetzbare Verstärkerkaskade mit großer Bandbreite anzugeben.

Die Aufgabe der Erfindung ist durch die Lehre der Ansprüche 1 oder 2 gelöst. Vorteilhafte Ausgestaltungen sind den abhängigen Ansprüchen zu entnehmen.

Das Wesen der Erfindung liegt in der Mehrfachausnutzung vorhandener Bauelemente, hier insbesondere des zur Kopplung zweier Transistorverstärkerstufen verwendeten Kondensators, der nun zusätzlich aufgrund geeigneter Verschaltung zur Spannungsgegenkopplung der Transistorverstärkerstufen benutzt wird. Durch die damit verbundene Reduzierung der Anzahl von Bauelementen und Zuleitungen erhält man einen kompakten Aufbau der Verstärkerkaskade, wodurch wiederum das Auftreten parasitärer Effekte, die die Bandbreite zu hohen Frequenzen hin begrenzen, verringert wird. Vorteilhafterweise verbessert sich zusätzlich die Stabilität, insbesondere bei hohen Frequenzen, und die Integrationsfreundlichkeit.

Zum besseren Verständnis der Erfindung ist im folgenden ein Ausführungsbeispiel anhand einer Figur beschrieben. Sie zeigt:
Ein Ausführungsbeispiel der erfindungsgemäßen Verstärkerkaskade.

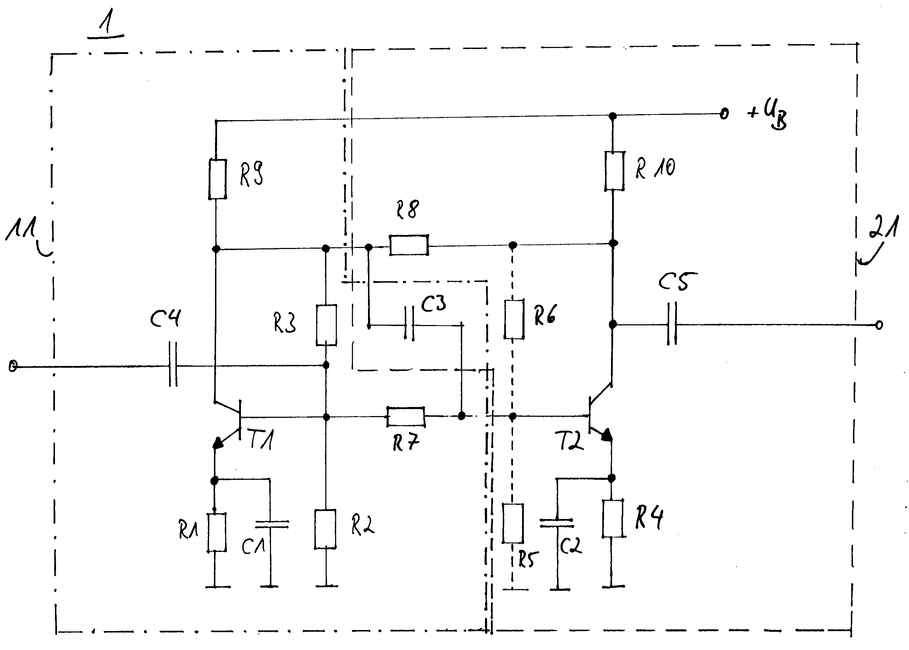

Ein in der Figur abgebildetes Ausführungsbeispiel zeigt eine Verstärkerkaskade 1 mit einer ersten Transistorverstärkerstufe 11, die einen ersten Transistor T1 in Emitterschaltung enthält, dessen Kollektor über einen ersten Kollektorwiderstand R9 mit dem positiven Anschluß einer Versorgungsspannung +U_{B} verbunden ist. Einen ersten Zweig zur Stormgegenkopplung 12 bildet eine Parallelschaltung aus einem ersten Widerstand R1 und einem ersten Kondensator C1, die den Emitter des ersten Transistors T1 mit Masse verbindet. Ein erster Basisteiler, bestehend aus einem zweiten Widerstand R2, der die Basis des ersten Transistors T1 mit Masse verbindet, und einem dritten Widerstand R3, der die Basis des ersten Transistors T1 mit seinem Kollektor verbindet, bestimmt den Arbeitspunkt der ersten Transistorverstärkerstufe 11.

Eine zweite Transistorverstärkerstufe 21 mit einem zweiten Transistor T2 in Emitterschaltung ist analog zu der ersten Transistorverstärkerstufe 11 aufgebaut und enthält einen zweiten Kollektorwiderstand R10, einen zweiten Zweig zur Stromgegenkopplung 22, bestehend aus einem vierten Widerstand R4 und einem zweiten Kondensator C2, und einen zweiten Basisteiler, bestehend aus einem fünften Widerstand R5 und einem sechsten Widerstand R6.

Die beiden Transistorverstärkerstufen 11 und 21 sind durch einen dritten Kondensator C3, der den Kollektor des ersten Transistors T1 mit der Basis des zweiten Transistors T2 verbindet, einen siebten Widerstand R7, der die Basen der beiden Transistoren T1 und T2 verbindet, und einen achten Widerstand R8, der die Kollektoren der beiden Transistoren T1 und T2 verbindet, miteinander gekoppelt.

Der dritte Kondensator C3 wird in dieser Verstärkerkaskade 1 3-fach ausgenutzt:
a) einmal wird er zur wechselstrommäßigen Kopplung der beiden Transistorverstärkerstufen 11 und 21 verwendet,
b) zum zweiten bildet er zusammen mit dem siebten Widerstand R7 einen Zweig zur Spannungsgegenkopplung in der ersten Transistorverstärkerstufe 11 und
c) desweiteren bildet er zusammen mit dem achten Widerstand R8 einen Zweig zur Spannungsgegenkopplung in der zweiten Transistorverstärkerstufe 21.

Über einen vierten Kondensator C4 wird ein Eingangssignal in die Verstärkerkaskade 1 eingekoppelt und über einen fünften Kondensator C5 eine dem Ausgangssignal überlagerte Gleichspannung abgetrennt. Die Verstärkerkaskade 1 wird also gleichstrommäßig von ihrer Quelle und ihrer Last entkoppelt, so daß letztere keinen Einfluß auf den Arbeitspunkt ausüben können.

Beide Transistorverstärkerstufen 11 und 21 haben jeweils eine Strom- und eine Spannungsgegenkopplung. Das ist für eine Leitungsanpassung am Ein- und Ausgang der Verstärkerkaskade 1 nützlich. Kriterien für die Qualität der Verstärkerkaskade 1 sind die Verstärkung, die Bandbreite, die Stabilität und die Reflexionseigenschaft. Im Vergleich zu einer einfachen Gegenkopplung hat man nun bei der Dimensionierung der Verstärkerkaskade 1 die Möglichkeit, einen besseren Kompromiß zwischen den vier Kriterien zu finden.

In den Zweigen zur Spannungsgegenkopplung wird der dritte Kondensator C3 benötigt, um die Kollektorgleichspannung von der Basis des jeweiligen Transistors T1 oder T2 fernzuhalten und damit eine Verschiebung des Arbeitspunktes des jeweiligen Transistors T1 oder T2 zu verhindern, die durch die Parallelschaltung von R3 und R7 in der ersten Transistorverstärkerstufe 11 und R6 und R8 in der zweiten Transistorverstärkerstufe 21 entstünde.

Eine in den Transistoren T1 oder T2 vorhandene Basis-Emitter-Grenzschichtkapazität erzeugt einen unerwünschten kapazitiven Eingangswiderstand der jeweiligen Transistorverstärkerstufe 11 oder 21, der die Stabilität, die Bandbreite und die Reflexionseigenschaften für hohe Frequenzen verringert. Um dem entgegenzuwirken, setzt man in die Zweige zur Stromgegenkopplung 12 und 22 den ersten Kondensator C1 und den zweiten Kondensator C2 ein. Beide Kondensatoren sind je nach Anwendungsfall nicht unbedingt notwendig. Die Reflexionseigenschaft der Verstärkerkaskade 1 wird durch die Kondensatoren C1 und C2 allerdings verschlechtert. Eine Maßnahme, dem wiederum entgegenzuwirken, ist das Einfügen einer nicht abgebildeten Induktivität in die Zweige zur Spannungsgegenkopplung in den beiden Transistorverstärkerstufen 11 und 21. Die Induktivitäten verringern die Wirkung des unerwünschten kapazitiven Eingangswiderstands der beiden Transistorverstärkerstufen 11 und 21.

Für viele Anwendungen der Verstärkerkaskade 1 werden keine unterschiedlichen Arbeitspunkte der beiden Transistorverstärkerstufen 11 und 21 benötigt. Die Potentiale von Kollektor und Basis der beiden Transistoren T1 und T2 sind bis auf etwa 10 % gleich. Es ist daher für diese Fälle nicht notwendig, für jeden der beiden Transistoren T1 und T2 einen Basisteiler zu haben, sondern es ist ausreichend, nur noch einen gemeinsamen Basisteiler zu verwenden. Dieser kann dann entweder aus der Kombination von R2 mit R3 oder R2 mit R6 oder R5 mit R3 oder R5 mit R6 bestehen. Der dritte Widerstand R3 kann, statt mit dem Kollektor des ersten Transistors T1, auch mit dem positiven Anschluß der Versorgungsspannung +U_{B} und der sechste Widerstand R6, statt mit dem Kollektor des zweiten Transistors T2, ebenfalls mit dem positiven Anschluß der Versorgungsspannung +U_{B} verbunden sein.

Anstelle einer Emitterschaltung können die Transistoren T1 und T2 auch in Kollektorschaltung beschaltet sein. Der im Ausführungsbeispiel beschriebene Aufbau und die Dimensionierung einzelner Bauelemente muß dann entsprechend geändert werden.

Anstelle der beschriebenen Bipolartransistoren T1 und T2 können auch Feldeffekttransistoren verwendet werden, die prinzipiell so wie die Bipolartransistoren im Ausführungsbeispiel angeordnet werden können. Die Dimensionierung der Beschaltung der Tansistoren T1 und T2 wird sich allerdings ändern. Die Anschlüsse - Drain, Gate und Source - sind entsprechend der äquivalenten bipolaren Anschlüsse - Kollektor, Basis und Emitter - zu verwenden.

Anstelle der einzelnen Transistoren T1 und T2 ist es auch möglich, mehrere Transistoren hintereinander zu schalten. Die Verwendung von Darlingtontransistoren ist z.B. eine geeignete Ausführung der Erfindung.

## Patentansprüche

1. Verstärkerkaskade (1) für Wechselspannungen mit zwei kaskadierten Transistorverstärkerstufen (11, 21), die jeweils wenigstens einen Bipolartransistor (T1, T2) in Emitter- oder Kollektorschaltung und gemeinsam wenigstens ein Mittel (R2, R3) zur Einstellung der Arbeitspunkte der Transistoren (T1, T2) haben und über einen Kondensator (C3) so miteinander gekoppelt sind, daß der Kondensator (C3) gleichzeitig über einen ersten Widerstand (R7), der zwischen den Basen der Transistoren (T1, T2) angeordnet ist, Teil einer Spannungsgegenkopplung für die erste Transistorverstärkerstufe (11) ist und daß der Kondensator (C3) über einen zweiten Widerstand (R8), der zwischen den Kollektoren der beiden Transistoren (T1, T2) angeordnet ist, Teil einer Spannungsgegenkopplung für die zweite Transistorverstärkerstufe (21) ist.

2. Verstärkerkaskade (1) für Wechselspannungen mit zwei kaskadierten Transistorverstärkerstufen (11, 21), die jeweils wenigstens einen Feldeffekttransistor (T1, T2) in Source- oder Drainschaltung und gemeinsam wenigstens ein Mittel (R2, R3) zur Einstellung der Arbeitspunkte der Transistoren (T1, T2) haben und über einen Kondensator (C3) so miteinander gekoppelt sind, daß der Kondensator (C3) gleichzeitig über einen ersten Widerstand (R7), der zwischen den Gates der Transistoren (T1, T2) angeordnet ist, Teil einer Spannungsgegenkopplung für die erste Transistorverstärkerstufe (11) ist und daß der Kondensator (C3) über einen zweiten Widerstand (R8), der zwischen den Drains der beiden Transistoren (T1, T2) angeordnet ist, Teil einer Spannungsgegenkopplung für die zweite Transistorverstärkerstufe (21) ist.

3. Verstärkerkaskade nach Anspruch 1 oder 2, dadurch gekennzeichnet, daß die Transistorverstärkerstufen (11, 21) einen gemeinsamen Basis- oder Gateteiler als Mittel zur Einstellung der Arbeitspunkte der Transistoren (T1, T2) haben.

4. Verstärkerkaskade nach Anspruch 1, 2 oder 3, dadurch gekennzeichnet, daß in Reihe zu dem ersten Widerstand (R7) eine erste Induktivität und in Reihe zu dem zweiten Widerstand (R8) eine zweite Induktivität geschaltet ist.

5. Verstärkerkaskade nach Anspruch 1 oder 2, dadurch gekennzeichnet, daß die Transistorverstärkerstufen (11, 21) jeweils eine Stromgegenkopplung (12, 22) haben.

6. Verstärkerkaskade nach Anspruch 1 oder 2, dadurch gekennzeichnet, daß sie eine Breitbandverstärkerschaltung ist.
